# EUROPEAN PATENT SPECIFICATION

(11) **EP 0 668 591 B1**
(45) Date of publication and mention of the grant of the patent: **20.10.1999**
(21) Application number: 94830074.4
(22) Date of filing: 18.02.1994
(51) Int. Cl.: G11C 7/00, G11C 16/06

(54) **Read timing method and circuit for nonvolatile memories**
Lesetaktsteuerungsverfahren und Schaltung für nichtflüchtige Speicher
Procédé et circuit de temporisation de lecture pour mémoires non volatiles

(43) Date of publication of application: 23.08.1995
(73) Proprietor: STMicroelectronics S.r.l., 20041 Agrate Brianza (Milano) (IT)
(72) Inventor: Pascucci, Luigi, I-20099 Sesto San Giovanni (IT); Padoan, Silvia, I-47037 Rimini (IT); Golla, Carla Maria, I-20099 Sesto San Giovanni (IT); Maccarrone, Marco, I-27030 Palestro (IT); Olivo, Marco, I-24100 Bergamo (IT)
(74) Representative: Cerbaro, Elena, Dr.

(56) References cited:
- EP-A- 0 322 901
- EP-A- 0 560 623
- US-A- 4 827 454

## Description

The present invention relates to a read timing method and circuit for nonvolatile memories.

As is known, increasing demand exists for memories characterized by flexibility, low consumption and immunity to noise, which characteristics are extremely difficult to achieve simultaneously in that each can only be obtained at the expense of the others. As such, a trade-off is inevitable, bearing in mind the effect in terms of technological yield, and the impossibility of achieving an all-round solution suitable for all applications.

A timer, for example, is useful in reducing consumption but, being invariably rigid, responds poorly to certain inevitable technological changes which are better catered to by a static type architecture.

Moreover, a timed architecture, though it provides for solving certain noise, dissipation and speed problems, is limited in situations in which certain lines are brought only slowly up to the steady-state condition.

Countless additional factors (e.g. slow locations, component characteristic shift, localized nonuniform behaviour) also exist, which require specific measures for ensuring adequate reliability of the memory.

It is an object of the present invention to provide a timer which, taking into account the specific situations involved and notwithstanding the presence of conflicting requirements, provides for optimum performance of the memory.

According to the present invention, there is provided a read timing method and circuit for nonvolatile memories, as claimed respectively in Claims 1 and 5.

In practice, according to the invention, there is provided a flexible architecture for modulating the basic signals and cycle times at various points, and which is enabled by switching edges, is programmable and protected against noise.

A preferred, non-limiting embodiment of the present invention will be described by way of example with reference to the accompanying drawings, in which:
Figure 1 shows one embodiment of the timing circuit according to the present invention;
Figure 2 shows a plot of various signals in the Figure 1 circuit;

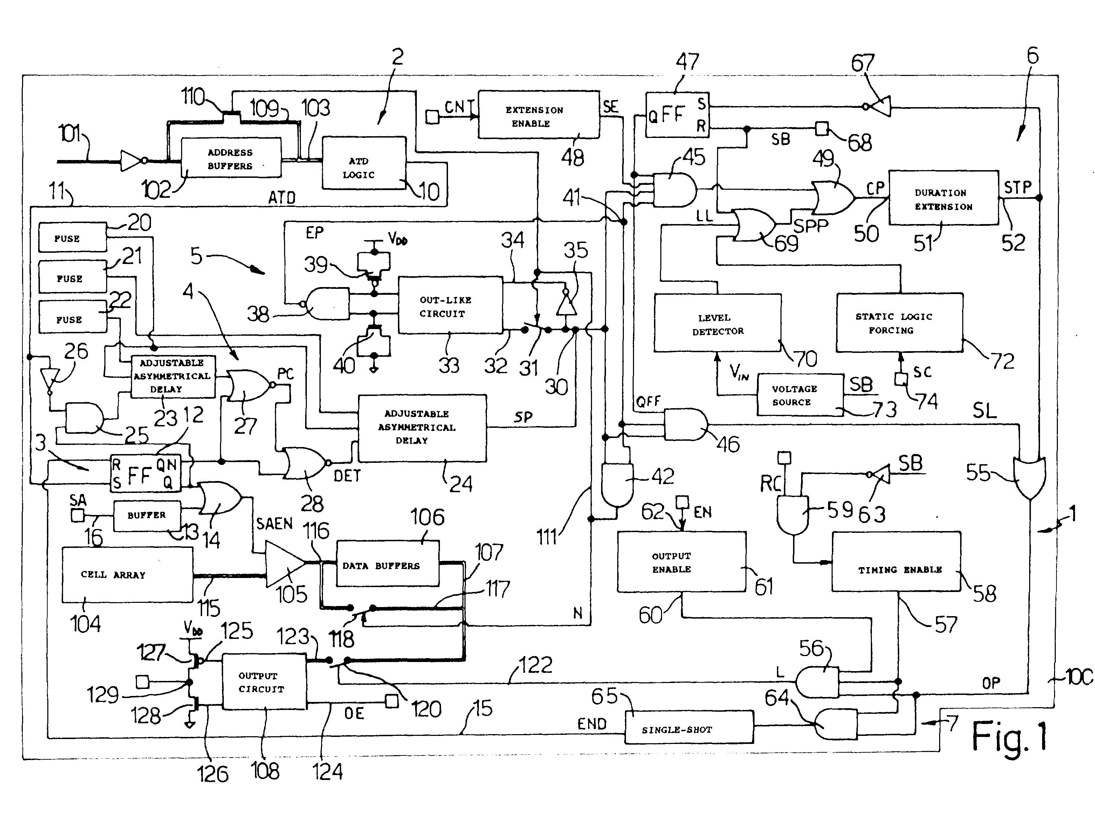

Number 1 in Figure 1 indicates a timing circuit forming part of a nonvolatile, conveniently flash type, memory 100 shown schematically and of which only a number of parts, timed by circuit 1, are shown. More specifically, of memory 100, Figure 1 shows: an external address bus 101; an address buffer unit 102; an internal address bus 103; a memory cell array 104; an amplifying unit 105; a data buffer unit 106; a data bus 107; and an output circuit 108.

Address buffer unit 102 is formed by a number of buffers, and is input-connected to external address bus 101, and output-connected to internal address bus 103. Unit 102 is feedback controlled by an address feedback bus 109 formed by a number of lines along which are provided switches controlled by a single control signal and of which only one is shown in the form of an N-channel transistor 110 with its gate terminal connected to a line 111 supplying a noise suppressing signal N. Feedback by line 109 prevents the data stored in the buffers of unit 102 from switching in the event of noise on output bus 103 or switching on bus 101, by "freezing" it to the previous value. Internal address bus 103 is connected to an address decoding section (not shown) and a logic unit 10 generating an asynchronous signal ATD as explained below.

Array 104 and amplifying unit 105 are connected by a bus 115; unit 105 (formed by a number of sense amplifiers) and data buffer 106 are connected by a bus 116; unit 106 (formed by a number of buffers) is feedback controlled by a data feedback bus 117 in turn formed by a number of lines along which are provided switches controlled by a single control signal and only one of which, 118, is shown with its control input connected to line 111. As in the case of line 109, feedback line 117 provides for blocking the data stored in the output buffers of unit 106 as long as switches 119 are closed, and regardless of any noise generated on data bus 107 by switching of output unit 108, by virtue of the buffer outputs of unit 106 presenting a much greater impedance with respect to the sense amplifier outputs of unit 105.

Data bus 107, also formed by a number of lines, presents a number of switches controlled by a single signal and of which only one, 120, is shown. The control terminal of switch 120 is connected to a line 122 supplying load signal L, so as to normally interrupt data bus 107 except for the time necessary for loading the data.

Output unit 108 is formed by a number of output circuits, each presenting two inputs 123, 124; each input 123 is connected to a respective line of data bus 117; and inputs 124 are all connected to an enabling line supplying a common enabling signal OE. The output circuits are typically formed by known latch circuits (not shown). For each output circuit, output unit 108 also presents two outputs 125, 126 connected to respective gate terminals of two transistors 127, 128. P-channel transistor 127 presents the source terminal connected to the supply (V_{DD}), and the drain terminal connected to an output node 129 to which is also connected the drain terminal of N-channel transistor 128, the source terminal of which is grounded.

Circuit 1 substantially comprises a section 2 generating a pulse signal ATD for asynchronously enabling timing circuit 1; a section 3 for enabling reading of the memory cells in array 104; a section 4 generating an equalizing (or precharge) signal PC and detecting signal DET, for controlling reading of the data from array 104 and data supply to unit 106; a section 5 generating a noise suppressing signal N; a section 6 generating a load signal L; and a section 7 generating an END signal for resetting the circuit.

Section 2 comprises logic unit 10 which detects a change in the addresses on internal address bus 103, and generates pulse signal ATD supplied along line 11.

Section 3 comprises a flip-flop 12, a buffer 13, and an OR circuit 14. Flip-flop 12 presents a set input S connected to line 11; a reset input R connected to a line 15 supplying the END pulse signal; and an output Q connected to a first input of OR circuit 14. Buffer 13 presents an input 16 supplied with a static read control signal SA supplied by memory 100; and an output connected to a second input of OR circuit 14. The output of OR circuit 14 is connected to the enabling input of amplifying unit 105.

Section 4 comprises three memory elements 20, 21, 22, the content of which may assume only two logic states for respectively determining slow or fast timing, a short or long precharge (or equalizing) phase, and a short or long detecting phase, depending on the specific characteristics of memory 100 determined at the debugging phase. The outputs of memory elements 20-22 are connected to two adjustable asymmetrical delay units 23, 24, both formed by a number of asymmetrical elementary delay stages cascade connected and bypassable by lines with switches controlled by the signals supplied by memory elements 20-22, for predetermining the duration of the precharge and detection phases and total timing, as described in detail in co-pending patent application entitled "Internal timing method and circuit for programmable memories." (EP-A-0 668 592, having the same filing date as the present application).

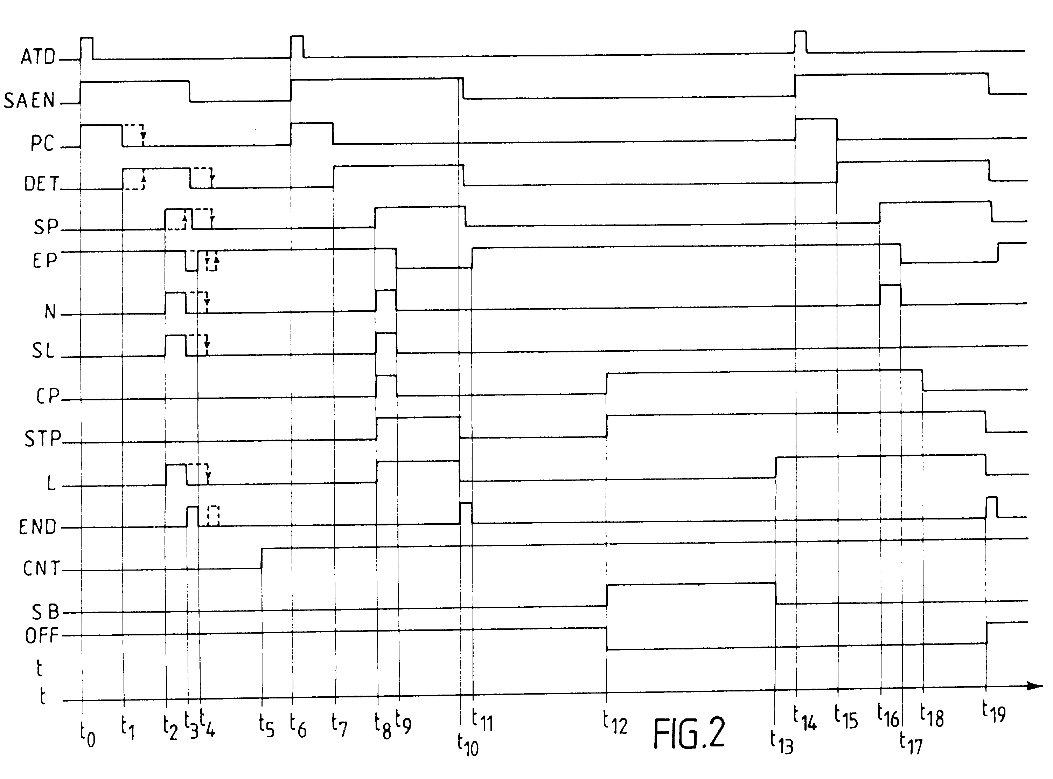

More specifically, delay unit 23 presents an enabling input connected to the output of an AND gate 25 in turn presenting a first input connected to output Q of flip-flop 12, and a second input connected to line 11 via an inverter 26. The output of delay unit 23 presents a normally-low signal which switches to high with a delay with respect to the instant at which the leading edge of signal ATD is received, such delay depending on the content of memory elements 20 and 22 as explained above (see also Figure 2). The output of delay unit 23 is connected to a first input of a NOR gate 27 having a second input connected to output QN of flip-flop 12. The output of NOR gate 27 (supplying signal PC) is connected to a first input of a further NOR gate 28 having a second input connected to output QN of flip-flop 12. The output of NOR gate 28 (supplying signal DET) is connected to an enabling input of asymmetrical delay unit 24, the output of which generates a data simulating signal SP which is normally low, and which, with respect to the instant at which the leading edge of signal DET is received, switches to high with a delay determined by the content of memory elements 20 and 21.

The output of delay unit 24 is connected to a node 30 and, via a controlled switch 31, to one input 32 of an out-like circuit 33 having a second input 34 connected to node 30 via an inverter 35. Out-like circuit 33 presents the same structure as the output circuits of unit 108, so as to reproduce exactly the same propagation delay, and, like the output circuits of unit 108, presents two outputs connected to respective transistors 39, 40 and to the inputs of a NAND gate 38. The drain and source terminals of P-channel transistor 39 are short-circuited and connected to supply line V_{DD}, while those of transistor 40 are short-circuited and grounded. Transistors 39, 40 present the same geometry as transistors 127, 128, so as to reproduce the same capacitance.

The output of NAND gate 38 (supplying signal EP) is connected to a node 41 in turn connected to a first input of an AND gate 42 which, together with components 31-40, forms section 5 generating signal N. AND gate 42 also presents a second input connected to node 30; and an output connected to line 111 supplying noise suppressing signal N.

Node 41 is also connected to one input of a four-input AND gate 45 and to one input of a three-input AND gate 46, both forming part of section 6 generating the load signal. Both gates 45 and 46 present a second input connected to node 30, and a third input connected to the output (supplying signal QFF) of a flip-flop 47 having a set input S and a reset input R.

The fourth input of AND gate 45 is connected to the output of an extension enabling block 48 having one input (supplied with signal CNT) and generating at the output an extension disabling signal SE, the logic value of which is determined by signal CNT and in turn provides for enabling or disabling extension of the load pulses. The output of AND gate 45 is connected to one input of an OR gate 49, the output of which is connected to the input 50 of a pulse duration extension block 51. Block 51 is composed substantially of a single-switching edge-delay single-shot circuit generating at output 52 an extended pulse signal STP which switches to high upon block 51 detecting a leading edge at input 50, and switches to low, with a predetermined delay adjustable to the characteristics of memory 100, upon the signal at input 50 switching to low.

Output 51 of block 50 and the output of AND gate 46 (supplying pulse signal SL) are connected to the inputs of an OR gate 55, the output of which (supplying signal OP) is connected to one input of an AND gate 56 having a second input connected to the output 57 of a timing enabling block 58 in turn presenting an input connected to the output of an AND gate 59. AND gate 59 presents a first input connected to the output of an inverter 63 supplied with a standby signal SB; and a second input supplied with a timing enabling signal RC. AND gate 56 presents a third input connected to the output 60 of an output enabling block 61 having an input 62 supplied with an enabling signal EN. AND gate 56 generates load signal L supplied along line 122. The output of OR gate 55 is also connected to a first input of an AND gate 64 having a second input connected to output 57 of block 58, and an output connected to a single-shot circuit 65, the output of which is connected to line 15 and generates the END pulse signal on detecting a trailing edge of the output signal from AND gate 64. Block 58 provides for blocking the timing signals when not required by memory 100, and block 61 for disabling data loading into the output circuits, while at the same time maintaining all the other timing functions enabled, as required for certain particular operating or test modes.

Output 52 of block 51 is also connected, via an inverter 67, to input S of flip-flop 47, the input R of which is connected to an input node 68 of circuit 1 supplying standby signal SB. Node 68 is also connected to a first input of an OR gate 69 having a second input connected to a level detector 70, and a third input connected to a static logic forcing block 72. Level detector 70 substantially comprises a threshold comparator supplied with a voltage V_{IN} related to the supply voltage and generated by a block 73, the input of which is supplied with standby signal SB. In steady state mode (low standby signal SB), voltage V_{IN} presents a predetermined value above the threshold of level detector 70 which therefore generates a low logic level (signal LL) at the output. Upon SB switching to low, voltage V_{IN} falls below the threshold of detector 70, the output LL of which therefore switches to high. When standby signal SB switches back to low, voltage V_{IN} is not restored immediately to the steady state value, due to the inertia of generator 73, so that signal LL remains high and only switches back to low when voltage V_{IN} once more rises above the threshold of detector 70.

Static logic forcing block 72 is connected to an input node 74 supplying a signal SC for setting a static operating mode (e.g. when testing). The output of OR gate 69 (supplying a static operation control signal SPP) is connected to one input of OR gate 49.

In circuit 1, signals OE, SA, SB, SC, CNT, EN, RC and voltage V_{IN} are supplied by memory 100.

Operation of the timing circuit will now be described with reference also to Figure 2.

To begin with, the circuit will be assumed to be in steady state operating mode with no extension of the load pulses, and wherein signals SA, CNT, SB and SC are low; signals OE, EN, RC and QFF are high; V_{IN} is above the predetermined threshold; static operating mode is therefore not activated; and the delays to be generated by units 23, 24 (and set by fuses 20-21) are minimum; which situation is shown by the continuous-line plots in Figure 2. Before the start of a reading phase, signals ATD, SAEN, PC, DET, SP, N, SL, SPP, CP STP, L and END are low, and signals EP and QFF are high.

Assuming the addresses on address bus lines 101 and 103 begin switching at instant t₀, this is detected by logic unit 10 which switches signal ATD to high where it remains until the last address switches. Low-to-high switching of ATD switches output Q of flip-flop 12 and hence signal SAEN to high (enabling sense amplifiers 105), and switches output QN of flip-flop 12 to low so that signal PC switches to high (the output of delay circuit 23 is still low). As such, signal DET remains low. In this phase, therefore, signal PC enables the precharge phase of array 100, wherein array 104 and unit 105 prepare for reading, and the output of AND gate 25 remains low due to the low output of inverter 26.

Upon signal ATD switching back to low, the output of AND gate 25 switches to high, which switching edge is transmitted to unit 23, the output of which switches to high with a predetermined delay (depending on the settings of memory elements 20 and 22). As soon as the output of unit 23 switches, signal PC switches back to low (as shown by the continuous line in Figure 2, instant t₁), so that signal DET switches to high (also shown by the continuous line), thus terminating the precharge phase and commencing the detecting phase of array 100, wherein the content, detected by the sense amplifiers, of the memory cells of array 104 is supplied to data buffer 106.

After a delay depending on the settings of memory elements 20 and 21, the output of delay circuit 24 also switches, so that signal SP switches to high (continuous line, instant t₂).

Consequently, being supplied with two "1", AND gate 42 switches, so that signal N switches to high, closing switches 31, 110, 118; and AND gate 46 also switches, so that short load signal SL switches to high. As extension of the load pulses is disabled (low output of AND gate 45, hence, low signal CP), signal STP remains low. The output of OR gate 55, however, switches to high, as does output signal L from AND gate 56, thus closing switch 120 and commencing the loading phase as indicated below.

Closure of switch 31 provides for supplying data simulating signal SP to input 32 of out-like circuit 33; and closure of switch 118 for freezing and so preventing undesired switching of the output buffers of unit 106. At the same time, the data in the output buffers of unit 106 begins to propagate in the output circuits (unit 108) which thus switch. Since, as already stated, output buffers 106 are prevented from switching at this phase, the noise generated by such switching (which involves high currents due to charging and discharging of the capacitive elements of the output circuits, and may thus alter the voltage levels in amplifiers 105) is prevented from damaging the data. Similarly, the addresses in buffer unit 102 are also frozen.

Signal SP is thus transmitted to out-like circuit 33 in the same way and simultaneously with the data to output circuits 108, and, at the end of transmission, the outputs of out-like circuit 33 switch to high; signal EP switches to low (continuous line, instant t₃) so that AND gates 42 and 46 switch; signal N switches back to low, opening switches 31, 110 and 118; load signal L also switches to low in that, as already stated, extension is disabled and STP is low; and switch 120 also opens thus terminating the data loading phase, which therefore lasts precisely as long as necessary for the data to propagate in output circuit 108.

Simultaneously with high-to-low switching of signal L, single-shot circuit 65 receives a trailing edge and generates a pulse; the signal END switches briefly to high, resetting and switching flip-flop 12; output Q of the flip-flop switches rapidly to low, thus switching signal SAEN and the output of AND gate 25 to low; the sense amplifiers of unit 105, which were kept on throughout reading of the signals, are disabled to reduce consumption; delay block 23, by virtue of being asymmetrical, is reset rapidly; and output QN of flip-flop 12 switches to high, thus switching signal DET and also SP to low. Switching of SP rapidly resets out-like circuit 33 which, at instant t₄, switches its outputs to low, thus switching circuit 38, so that signal EP switches to high to restore the initial conditions.

It should be pointed out that, by virtue of blocks 23, 24 being asymmetrical, the leading edge of an ATD pulse immediately after the previous ATD pulse (or at any rate before the END pulse is generated) immediately resets the delay lines (blocks 23, 24) via inverter 26 and AND gate 25, thus blanking any transmission in progress and restoring the initial conditions (the output of block 23, if already high, switches immediately to low, thus switching PC immediately to high and DET, and possibly SP, to low), and starts the precharge and equalizing (or detecting) phases from the beginning, so that the delays with which data simulating signal SP is generated as of the last ATD pulse are always the same.

Operation as described above is repeated whenever switching of the addresses is detected and logic unit 10 generates an ATD signal pulse, and as long as signal CNT is low and no static, standby or low-power operating conditions are present.

Figure 2 also shows the timing obtained with a longer delay setting of unit 23 and a minimum delay setting of unit 24. For comparison purposes, the slower timing is indicated by the dotted line over the faster timing described above. In this case, PC switches to zero with a delay as compared with previously, thus resulting in a corresponding delay in the switching of the other signals. Similarly, the delay with which unit 24 switches on receiving the trailing edge of CP may be increased, to vary the duration of the precharge and detecting phases as well as the overall duration of the cycle, according to the speed characteristics of memory array 104, so as to set the minimum delay for ensuring reading of most of the elements of array 104.

If, on the other hand, extension of the load signal is enabled, data loading into output circuit unit 108 continues even after the end of the signal N pulse, as described below.

Assuming signal CNT switches to high at instant t₅, in this case, as previously, SAEN and PC immediately switch to high when the pulse ATD is generated (instant t₆). After the predetermined delay (instant t₇), PC again switches to low, and DET to high; and, at instant t₈, signals SP, N and SL switch to high. In this case, signal SE being high, the output of AND gate 45 also switches so that signals PC, STP, OP and L switch to high.

Switches 31, 110, 118 and 120 therefore close, and the data simulating signal begins propagation in out-like circuit 33, and the data in output unit 108. At the same time, the data in address buffers 102 and output buffers 106 is frozen.

As previously, switching of the outputs of circuit 33 and NAND gate 38 switches signal EP to low (instant t₉) and terminates the pulses of signals N, SL and CP to open switches 31, 110 and 118. In this case, however, signal STP remains high for the time determined by block 51, so that load signal L remains high and switch 120 closed, and any delayed data supplied by sense amplifiers switching after most of the others, due to the delay of corresponding elements of array 104, may be loaded by the output buffers of unit 106 into corresponding output circuits of unit 108.

At instant t₁₀, signals STP and L also switch to low, thus opening switches 120 and separating the output circuits from buffer unit 106. As previously, high-to-low switching of signal STP results in similar switching of the output of AND gate 64, thus enabling single-shot circuit 65 which generates an END signal pulse to reset flip-flop 12. Outputs Q and QN of the flip-flop therefore switch to low and high respectively, so that signals SAEN, DET and SP switch to low. At instant t₁₁, signal EP switches to high to restore circuit 1 to the reset condition.

Operation as described above is repeated as long as signal SB remains low. Supposing, now, memory 100 switches to standby at instant t₁₂. Switching of SB resets flip-flop 47, the output signal QFF of which switches to low, thus disabling AND gates 45 and 46 and switching static operating signal SPP to high. CP therefore switches to high, as does STP. Switching of SB switches inverter 63, the output of which switches to low, as does the output of AND gate 59, which therefore disables timing (low signal at output 57 of block 58) so that L remains low. In this phase, signal LL switches to high due to the fall in voltage V_{IN} caused by switching of SB.

The above condition continues as long as signal SB remains high. When SB switches to low (instant t₁₃), signal L switches to high, due to switching of inverter 63 and AND gate 59, thus permitting reading in static mode. The rest of the circuit, however, remains unchanged in that, as already stated, it takes some time for V_{IN} to reach the steady state condition, during which interval LL therefore remains high. In this condition, even if a pulse ATD is generated (as shown at instant t₁₄), section 6 generating the load signal remains in static mode as described below. Generation of the pulse ATD in fact produces the phase sequence described above with reference to sections 2-5, so that, at instant t₁₄, SAEN and PC switch to high; at instant t₁₅, PC switches to low and DET to high; at instant t₁₆, SP and N switch to high; being disabled, gates 45, 46 do not switch (SL remains low); L remains high; and, at instant t₁₇, EP and N switch to low with no change in the state of section 6.

Assuming, now, that at instant t₁₈ controlled voltage V_{IN} again exceeds the predetermined threshold, so that LL, SPP and CP switch to low. In this condition, the load signal remains high to permit reading long enough to ensure correct data acquisition despite the previous critical condition. After the predetermined delay (instant t₁₉), signal STP switches to low, so that signal L also switches to low, and single-shot circuit 65 generates a pulse END pulse to reset flip-flip 12 and sections 3-5 and switch SAEN, DET, SP and EP. Switching of signal STP also sets flip-flop 47 and re-enables gates 45, 46, thus terminating the static operating phase and restoring the circuit to normal operating mode as described above (instants t₆-t₁₁).

The same static operation is enabled if requested by memory 100 or other devices connected to it (e.g. for special functions, such as testing, checking data from registers or other parts of the memory, etc.) via signal SC at input 41, and in the event, for any reason, of a fall in voltage (V_{IN} below the predetermined threshold) which may result in reading errors.

If timing is disabled (low signal RC), the output of AND gate 59, and hence of block 58, is low and disables AND gates 56, 64. At the end of timing, therefore, no reset signal END is generated, so that the whole of circuit 1 is in fact disabled. Signal EN, on the other hand, as already stated, disables data loading to output 129.

The circuit described therefore provides for a timed architecture (and hence an intrinsic reduction in consumption and noise, and high speed) which nevertheless takes into account any technological differences, slow-speed situations or local problems, by modulating at various points the basic signals and cycle times. More specifically, the circuit and method according to the present invention provide for adjusting the data read and load times between the memory array and sense amplifiers to take into account the time required by the majority of the elements. The possibility of regulating the duration of the load pulse also provides for salvaging any very slow elements, with no need for an excessive increase in precharging and, especially, evaluation time (which would result in an unacceptable increase in noise), or for renouncing the slower elements, thus also reducing the need for redundant elements. Freezing the data and addresses during external loading of most of the data provides for effectively eliminating a major source of noise and ensuring highly reliable operation of the memory. Loading of any slower data after freezing, by generating an extended load signal, does not involve a serious amount of noise in view of the much smaller number of outputs switching in this phase. Finally, by virtue of the out-like circuit, the freezing phase and at least the first part of the loading phase are so set as to present as short a duration as possible, thus providing for the maximum cycle speed compatible with the characteristics of the memory, while at the same time ensuring the data of most of the memory elements is fully loaded into the output elements. The architecture described is also capable of operating in static mode when necessary, e.g. in the event the conditions of the circuit are not definitely known.

Clearly, changes may be made to the method and circuit as described and illustrated herein without, however, departing from the scope of the present invention.

## Claims

1. A read timing method for a nonvolatile memory (100) comprising at least an output element (108), a buffer unit (106), and an out-like unit (33) presenting a same propagation time as said output element (108); said method comprising, in combination, the steps of:
generating a read enabling signal (ATD);
enabling a precharge phase of predetermined adjustable duration on receiving said read enabling signal;
enabling an evaluation phase at the end of said precharge phase;
generating a data simulating signal (SP) a predetermined adjustable time after enabling said evaluation phase;
enabling propagation of said simulating signal (SP) in said out-like unit (33), and simultaneously enabling data loading from said buffer unit (106) in said output element (108) by a load signal (L), and disabling switching of said buffer unit (106);
interrupting said step of disabling switching, on detecting propagation of said simulating signal (SP) through said out-like unit (33);
interrupting said loading phase after a predetermined adjustable delay; and
resetting said nonvolatile memory (100) following disabling of said load signal (L).

2. A method as claimed in Claim 1, characterized in that said steps of enabling a precharge phase and an evaluation phase each comprise the step of generating a precharge enabling signal (ATD) and, respectively, evaluation enabling signal (DET); transmitting said precharge enabling signal and, respectively, said evaluation enabling signal along a respective propagation line (23, 24); and selectively enabling predetermined delays on said respective propagation line according to the speed characteristics of said nonvolatile memory (100).

3. A method as claimed in Claim 1 or 2, characterized in that said step of enabling propagation comprises the step of supplying said data simulating signal (SP) to said out-like unit (33); said out-like unit being identical to said output element (108).

4. A method as claimed in one of the foregoing Claims, characterized in that said steps of enabling and interrupting a loading phase comprise the step of generating a short pulse (SL) simultaneously with said step of disabling switching; interrupting said short pulse simultaneously with said step of interrupting said step for disabling switching; generating a long pulse (STP) from said short pulse, said long pulse being enabled simultaneously with said short pulse and being disabled with a predetermined delay with respect to said short pulse; and selectively picking up said long pulse or said short pulse.

5. A read timing circuit for a nonvolatile memory (100) comprising at least an output element (108) and a data buffer unit (106); said circuit (1) comprising read enabling means (10) for generating a read enabling signal (ATD); precharge enabling means (27) enabled by said read enabling signal (ATD); and detection enabling means (28) for generating a detection enabling signal (DET); characterized in that it comprises:
duration modifying means (23) for disabling said precharge enabling means (27) and enabling said detection enabling means (28) a predetermined adjustable time after receiving said read enabling signal (ATD);
simulating generator means (24) enabled by said detection enabling means (28), for generating a data simulating signal (SP) a predetermined adjustable time after receiving said detection enabling signal (DET);
an out-like circuit (33) having the same propagation time as said output element (108) and connected to said simulating generator means (24);
data blocking means (117, 118) connected to said data buffer unit (106), for preventing switching of said data buffer unit;
simultaneous enabling means (31, 42, 46, 120) for said out-like circuit (33), said output element (108) and said data blocking means (117, 118), for simultaneously propagating said data simulating signal (SP) in said out-like circuit (33), loading data from said data buffer unit (106) to said output element (108) and disabling said data buffer unit (106),
propagation detecting means (38) connected to said out-like circuit (33), for generating a disabling signal (EP) for said simultaneous enabling means (31, 42, 46, 120);
load extending means (51) for generating an extended load signal (STP) for said output element (108) ; selective enabling means (45, 69) for selectively enabling said load extending means; and
circuit resetting means (65).

6. A circuit as claimed in Claim 5, characterized in that said out-like circuit (33) is identical to said output element (108).

7. A circuit as claimed in Claim 5 or 6, characterized in that said data blocking means (117, 118) comprise a feedback line (117) connecting the input and output of said data buffer unit (106); and first switching means (118) located on said feedback line and controlled by said simultaneous enabling means (31, 42, 46, 120).

8. A circuit as claimed in one of the foregoing Claims from 5 to 7, characterized in that said simultaneous enabling means (31, 42, 46, 120) comprise first logic circuits (42) connected to said simulating generator means (24) and to said propagation detecting means (38), for generating a noise suppressing signal (N) for enabling said data blocking means (117, 118); second logic circuits (46) connected to said simulating generator means and to said propagation detecting means (38), for generating a data loading signal (SL); second switching means (31) interposed between said simulating generator means (24) and said out-like circuit (33) and having a control terminal supplied with said noise suppressing signal; and third switching means (120) interposed between said data buffer unit (106) and said output circuit (108) and having a control terminal supplied with said data loading signal.

9. A circuit as claimed in Claim 8, in a nonvolatile memory (100) also comprising an address buffer unit (102); characterized in that it also comprises address blocking means (109, 110) connected to said first logic circuits (42) and to said address buffer unit (102), for preventing switching of said address buffer unit in the presence of said noise suppressing signal (N).

10. A circuit as claimed in one of the foregoing Claims from 5 to 9, characterized in that said load extending means comprise delay means (51) having an input connected to said simulating generator means (24) and supplied with said data simulating signal (SP); a second input connected to said propagation detecting means (38) and supplied with said disabling signal (EP); and an output supplying said extended load signal (STP) enabled upon reception of said data simulating signal and disabled with a predetermined delay upon detection of said disabling signal.

11. A circuit as claimed in one of the foregoing Claims from 5 to 10, characterized in that said selective enabling means (45, 69) comprise fourth switching means (45) interposed between said simultaneous enabling means (31, 42, 46, 120) and said load extending means (51), and having at least one control terminal connected to extension disabling means (47, 48).

12. A circuit as claimed in Claim 11, characterized in that said selective enabling means (45, 69) also comprise static mode setting means (69) generating a static mode signal (SPP) for continuously enabling said load extending means (51).

13. A circuit as claimed in one of the foregoing Claims from 8 to 12, characterized in that it comprises selecting means (55) having a first input connected to said simultaneous enabling means (46); a second input connected to said load extending means (51); and an output connected to said control terminal of said third switching means (120); and in that said resetting means comprise monostable means (65) having an input connected to said selecting means (55); and an output connected to said precharge enabling means (27).

## Patentansprüche

1. Ein Lesetaktsteuerungsverfahren für einen nichtflüchtigen Speicher (100), der zumindest ein Ausgangselement (108), eine Puffereinheit (106) und eine ausgangsähnliche Einheit (33) umfaßt, die die gleiche Laufzeit wie das genannte Ausgangselement (108) aufweist; wobei das genannte Verfahren in Kombination die Schritte umfaßt:
Erzeugen eines Lesefreigabesignals (ATD);
Freigeben einer Vorladephase vorbestimmter einstellbarer Länge bei Erhalt des genannten Lesefreigabesignals;
Ermöglichen einer Auswertungsphase am Ende der genannten Vorladephase;
Erzeugen eines Datensimuliersignals (SP) zu einer vorbestimmten, einstellbaren Zeit nach der Freigabe der genannten Auswertungsphase;
Freigeben der Fortpflanzung des genannten Simulationssignals (SP) in der genannten ausgangsähnlichen Einheit (33) und gleichzeitiges Freigeben des Datenladens von der genannten Puffereinheit (106) in das genannte Ausgangselement (108) durch ein Ladesignal (L) und Sperren, die genannte Puffereinheit (106) zu schalten;
Unterbrechen des genannten Schritts, das Schalten zu sperren, beim Erfassen der Fortpflanzung des genannten Simulationssignals (SP) durch die genannte ausgangsähnliche Einheit (33);
Unterbrechen der genannten Ladephase nach einer vorbestimmten einstellbaren Verzögerung; und
Rücksetzen des genannten nichtflüchtigen Speichers (100) nach dem Sperren des genannten Ladesignals (L).

2. Ein Verfahren, wie in Anspruch 1 beansprucht, **dadurch gekennzeichnet,** daß die genannten Schritte, eine Vorladephase und eine Auswertungsphase freizugeben, jeweils den Schritt umfassen, ein Vorladefreigabesignal (ATD) bzw. ein Auswertungsfreigabesignal (DET) zu erzeugen, das genannte Vorladefreigabesignal bzw. das genannte Auswertungsfreigabesignal auf einer jeweiligen Fortpflanzungsleitung (23, 24) zu übertragen, und selektiv vorbestimmte Verzögerungen auf der genannten jeweiligen Fortpflanzungsleitung gemäß den Geschwindigkeitseigenschaften des genannten nichtflüchtigen Speichers (100) freizugeben.

3. Ein Verfahren, wie in Anspruch 1 oder 2 beansprucht, **dadurch gekennzeichnet,** daß der genannte Schritt, die Fortpflanzung freizugeben, den Schritt umfaßt, das genannte Datensimulationssignal (SP) der genannten ausgangsähnlichen Einheit (33) zuzuführen, wobei die genannte ausgangsähnliche Einheit identisch mit dem genannten Ausgangselement (108) ist.

4. Ein Verfahren, wie in einem der vorgenannten Ansprüche beansprucht, **dadurch gekennzeichnet,** daß die genannten Schritte, eine Ladephase freizugeben und zu unterbrechen, den Schritt umfassen, einen kurzen Impuls (SL) gleichzeitig mit dem genannten Schritt, das Schalten zu sperren, zu erzeugen, den genannten kurzen Impuls gleichzeitig mit dem genannten Schritt zu unterbrechen, den genannten Schritt zum Sperren des Schaltens zu unterbrechen, einen langen Impuls (STP) von dem genannten kurzen Impuls zu erzeugen, wobei der genannte lange Impuls gleichzeitig mit dem genannten kurzen Impuls freigegeben und mit einer vorbestimmten Verzögerung in bezug auf den genannten kurzen Impuls gesperrt wird, und selektiv den genannten langen Impuls oder den genannten kurzen Impuls aufzunehmen.

5. Eine Lesetaktsteuerungsschaltung für einen nichtflüchtigen Speicher (100), die zumindest ein Ausgangselement (108) und eine Datenpuffereinheit (106) umfaßt, wobei die genannte Schaltung (1) eine Lesefreigabeeinrichtung (10) zur Erzeugung eines Lesefreigabesignals (ATD), eine Vorladefreigabeeinrichtung (27), die durch das genannte Lesefreigabesignal (ATD) freigebbar ist, und eine Erfassungsfreigabeeinrichtung (28) zur Erzeugung eines Erfassungsfreigabesignals (DET) umfaßt, **dadurch gekennzeichnet,** daß sie umfaßt:
eine Zeitdauerabänderungseinrichtung (23), um die genannte Vorladefreigabeeinrichtung (27) zu sperren und die genannte Erfassungsfreigabeeinrichtung (28) eine vorbestimmte einstellbare Zeit nach Erhalt des genannten Lesefreigabesignals (ATD) freizugeben;
eine Simulationsgeneratoreinrichtung (24), die durch die genannte Erfassungsfreigabeeinrichtung (28) freigegeben wird, um ein Datensimulationssignal (SP) zu einer vorbestimmten einstellbaren Zeit nach Erhalt des genannten Erfassungsfreigabesignals (DET) zu erzeugen;
eine ausgangsähnliche Schaltung (33), die die gleiche Laufzeit wie das genannte Ausgangselement (108) aufweist und mit der genannten Simulationsgeneratoreinrichtung (24) verbunden ist;
eine Datensperreinrichtung F(117, 118), die mit der genannten Datenpuffereinheit (106) verbunden ist, um das Schalten der genannten Datenpuffereinheit zu verhindern;
eine gleichzeitige Freigabeeinrichtung (31, 42, 46, 120) für die genannte ausgangsähnliche Schaltung (33), das genannte Ausgangselement (108) und die genannte Datensperreinrichtung (117, 118), um gleichzeitig das genannte Datensimulationssignal (SP) in der genannten ausgangsähnlichen Schaltung (33) fortzupflanzen, Daten von der genannten Datenpuffereinheit (106) in das genannte Ausgangselement (108) zu laden und die genannte Datenpuffereinheit (106) zu sperren;
eine Laufzeiterfassungseindchtung (38), die mit der genannten ausgangsähnlichen Schaltung (33) verbunden ist, um ein Sperrsignal (EP) für die genannte gleichzeitige Freigabeeinrichtung (31, 32, 46, 120) zu erzeugen;
eine Ladeverlängerungseinrichtung (51), um ein verlängertes Ladesignal (STP) für das genannte Ausgangselement (108) zu erzeugen;
eine selektive Freigabeeinrichtung (45, 69), um selektiv die genannte Ladeverlängerungseinrichtung freizugeben; und
eine Schaltungsrücksetzeinrichtung (65).

6. Eine Schaltung, wie in Anspruch 5 beansprucht, **dadurch gekennzeichnet,** daß die genannte ausgangsähnliche Schaltung (33) mit dem genannten Ausgangselement (108) identisch ist.

7. Eine Schaltung, wie in Anspruch 5 oder 6 beansprucht, **dadurch gekennzeichnet,** daß die genannte Datensperreinrichtung (117, 118) eine Rückkopplungsleitung (117), die den Eingang und den Ausgang der genannten Datenpuffereinheit (106) verbindet, und eine erste Schaltereinrichtung (118) umfaßt, die sich auf der genannten Rückkopplungsleitung befindet und durch die genannte gleichzeitige Freigabeeinrichtung (31, 42, 46, 120) gesteuert wird.

8. Eine Schaltung, wie in einem der vorhergehenden Ansprüche 5 bis 7 beansprucht, **dadurch gekennzeichnet,** daß die genannte gleichzeitige Freigabeeinrichtung (31, 42, 46, 120) umfaßt erste Logikschaltungen (42), die mit der genannten Simulationsgeneratoreinrichtung (24) und der genannten Fortpflanzungserfassungseinrichtung (38) verbunden ist, um ein Rauschunterdrückungssignal (N) zur Freigabe der genannten Datensperreinrichtung (117, 118) zu erzeugen, zweite Logikschaltungen (46), die mit der genannten Simulationsgeneratoreinrichtung und mit der genannten Fortpflanzungserfassungseinrichtung (38) verbunden sind, um ein Datenladesignal (SL) zu erzeugen, die zweite Schaltereinrichtung (31) zwischen der genannten Simulationsgeneratoreinrichtung (24) und der genannten ausgangsähnlichen Schaltung (33) geschaltet ist und eine Steuerklemme aufweist, der das genannte Rauschunterdrückungssignal zugeführt wird, und eine dritte Schaltereinrichtung (120), die zwischen der genannten Datenpuffereinheit (106) und der genannten Ausgangsschaltung (108) geschaltet ist und eine Steuerklemme aufweist, der das genannte Datenladesignal zugeführt wird.

9. Eine Schaltung, wie in Anspruch 8 beansprucht, in einem nichtflüchtigen Speicher (100), die auch eine Adressenpuffereinheit (102) umfaßt, **dadurch gekennzeichnet,** daß sie auch eine Adressensperreinrichtung (109, 110) umfaßt, die mit den genannten ersten Logikschaltungen (42) und der genannten Adressenpuffereinheit (102) verbunden ist, um das Schalten der genannten Adressenpuffereinheit bei Gegenwart des genannten Rauschunterdrückungssignals (N) zu verhindern.

10. Eine Schaltung, wie in einem der vorhergehenden Ansprüche von 5 bis 9 beansprucht, **dadurch gekennzeichnet,** daß die genannte Ladeverlängerungseinrichtung eine Verzögerungseinrichtung (51) umfaßt, die einen Eingang, der mit der genannten Simulationsgeneratoreinrichtung (24) verbunden ist und dem das genannte Datensimulationssignal (SP) zugeführt wird, einen zweiten Eingang, der mit der genannten Fortpflanzungserfassungseinrichtung (38) verbunden ist und dem das genannte Sperrsignal EP zugeführt wird, und einen Ausgang aufweist, der das genannte verlängerte Ladesignal (STP) liefert, das bei Erhalt des genannten Datensimulationssignals freigegeben und durch eine vorbestimmte Verzögerung bei Erfassung des genannten Sperrsignals gesperrt wird.

11. Eine Schaltung, wie in einem der vorhergehenden Ansprüche 5 bis 10 beansprucht, **dadurch gekennzeichnet,** daß die genannte selektive Freigabeeinrichtung (45, 69) eine vierte Schaltereinrichtung (45) umfaßt, die zwischen die genannte gleichzeitige Freigabeeinrichtung (31, 42, 46, 120) und die genannte Ladeverlängerungseinrichtung (51) geschaltet ist und zumindest einen Steueranschluß aufweist, der mit der Verlängerungssperreinrichtung (47, 48) verbunden ist.

12. Eine Schaltung, wie in Anspruch 11 beansprucht, **dadurch gekennzeichnet,** daß die genannte selektive Freigabeeinrichtung (45, 69) auch eine statische Moduseinstelleinrichtung (69) umfaßt, um ein statisches Modussignal (SPP) zu erzeugen, damit die genannte Ladeverlängerungseinrichtung (51) fortlaufend freigegeben ist.

13. Eine Schaltung, wie in einem der vorhergehenden Ansprüche 8 bis 12 beansprucht, **dadurch gekennzeichnet,** daß sie eine Auswähleinrichtung (55) umfaßt, die einen ersten Eingang, der mit der genannten gleichzeitigen Freigabeeinrichtung (46) verbunden ist, einen zweiten Eingang, der mit der genannten Ladeverlängerungseinrichtung (51) verbunden ist, und einen Ausgang aufweist, der mit der genannten Steuerklemme der genannten dritten Schalteinrichtung (120) verbunden ist, und daß die genannte Rücksetzeinrichtung eine monostabile Einrichtung (65) umfaßt, die einen mit der genannten Auswähleinrichtung (55) verbundenen Eingang und einen Ausgang aufweist, der mit der genannten Vorladefreigabeeinrichtung (27) verbunden ist.

## Revendications

1. Procédé de temporisation de lecture pour une mémoire non-volatile (100) comprenant au moins un élément de sortie (108), un module tampon (106) et un module semblable à une sortie (33) présentant le même temps de propagation que l'élément de sortie (108), ce procédé comprenant en combinaison les étapes suivantes :
produire un signal de validation de lecture (ATD) ;
valider une phase de précharge de durée réglable prédéterminée à la suite de la réception du signal de validation de lecture ;
valider une phase d'évaluation à la fin de la phase de précharge ;
produire un signal de simulation de données (SP) après une durée prédéterminée après la validation de la phase d'évaluation ;
valider la propagation du signal de simulation (SP) dans le module analogue à une sortie (33) et, simultanément, valider la charge des données à partir du module tampon (106) dans l'élément de sortie (108) et invalider la commutation du module tampon (106) par un signal de charge (L) ;
interrompre l'étape d'invalidation de commutation, lors de la détection de la propagation du signal de simulation (SP) par l'intermédiaire du module analogue à une sortie (33) ;
interrompre la phase de charge après un retard réglable prédéterminé ; et
remettre à zéro la mémoire non-volatile (100) après invalidation du signal de charge (L).

2. Procédé selon la revendication 1, caractérisé en ce que les étapes de validation d'une phase de précharge et d'une phase d'évaluation comprennent chacune l'étape consistant à produire un signal de validation de précharge (ATD) et respectivement un signal de validation d'évaluation (DET) ; transmettre le signal de validation de précharge et, respectivement, le signal de validation d'évaluation le long d'une ligne de propagation respective (23, 24) ; et valider sélectivement des retards prédéterminés sur la ligne de propagation respective en fonction des caractéristiques de vitesse de la mémoire non-volatile (100).

3. Procédé selon la revendication 1 ou 2, caractérisé en ce que l'étape de validation de propagation comprend l'étape consistant à fournir ledit signal de simulation de données (SP) au module analogue à une sortie (33), le module analogue à une sortie étant identique à l'élément de sortie (108).

4. Procédé selon l'une quelconque des revendications précédentes, caractérisé en ce que les étapes de validation et d'interruption d'une phase de charge comprennent les étapes consistant à produire une impulsion courte (SL) en même temps que l'étape d'invalidation de commutation ; interrompre l'impulsion courte en même temps que l'étape d'interruption de l'étape d'invalidation de commutation ; produire une impulsion longue (STP) à partir de ladite impulsion courte, l'impulsion longue étant validée en même temps que l'impulsion courte et étant invalidée avec un retard prédéterminé par rapport à l'impulsion courte ; et détecter sélectivement l'impulsion longue ou l'impulsion courte.

5. Circuit de temporisation de lecture pour mémoire non-volatile (100) comprenant au moins un élément de sortie (108) et un module tampon de données (106) ; le circuit (1) comprenant un moyen de validation de lecture (10) pour produire un signal de validation de lecture (ATD) ; un moyen de validation de précharge (27) validé par le signal de validation de lecture (ATD) et un moyen de validation de détection (28) pour produire un signal de validation de détection (DET) ; caractérisé en ce qu'il comprend :
un moyen de modification de durée (23) pour invalider le moyen de validation de précharge (27) et pour valider le moyen de validation de détection (28) après un temps réglable prédéterminé après réception du signal de validation de lecture (ATD) ;
un moyen de générateur de simulation (24) validé par le moyen de validation de détection (28) pour produire un signal de simulation de données (SP) après un retard réglable prédéterminé après réception du signal de validation de détection (DET) ;
un circuit analogue à une sortie (33) ayant le même temps de propagation que l'élément de sortie (108) et connecté au moyen de générateur de simulation (24) ;
un moyen de blocage de données (117, 118) connecté au module tampon de données (106) pour empêcher la commutation du module tampon de données ;
un moyen de validation simultané (31, 42, 46, 120) pour le circuit analogue à une sortie (33), l'élément de sortie (108) et l'élément de blocage de données (117, 118) pour, simultanément, faire se propager le signal de simulation de données (SP) dans le circuit analogue à une sortie (33), charger des données à partir du module tampon de données (106) vers l'élément de sortie (108), et invalider le module tampon de données (106) ;
un moyen de détection de propagation (38) connecté au circuit analogue à une sortie (33) pour produire un signal d'invalidation (EP) pour le moyen de validation simultané (31, 42, 46, 120) ;
un moyen d'extension de chargement (51) pour produire un signal de chargement allongé (STP) pour l'élément de sortie (108) ;
un moyen de validation sélectif (45, 69) pour valider sélectivement le moyen d'extension de chargement ; et
un moyen de remise à zéro (65) du circuit.

6. Circuit selon la revendication 5, caractérisé en ce que le circuit analogue à une sortie (33) est identique à l'élément de sortie (108).

7. Circuit selon la revendication 5 ou 6, caractérisé en ce que le moyen de blocage de données (117, 118) comprend une ligne de réaction (117) reliant l'entrée et la sortie du module tampon de données (106) ; et un premier moyen de commutation (118) disposé sur la ligne de réaction et commandé par le moyen de validation simultané (31, 42, 46, 120).

8. Circuit selon l'une quelconque des revendications 5 à 7, caractérisé en ce que le moyen de validation simultané (31, 42, 46, 120) comprend un premier circuit logique (42) connecté au moyen générateur de simulation (24) et au moyen de détection de propagation (38) pour produire un signal de suppression de bruit (N) pour valider le moyen de blocage de données (117, 118) ; un second circuit logique (46) connecté au moyen générateur de simulation et au moyen de détection de propagation (38) pour produire un signal de chargement de données (SL) ; un second moyen de commutation (31) interposé entre le moyen générateur de simulation (24) et le circuit analogue à une sortie (33) et ayant une borne de commande alimentée par le signal de suppression de bruit ; et un troisième moyen de commutation (120) interposé entre le module tampon de données (106) et le circuit de sortie (108) et ayant une borne de commande alimentée par le signal de chargement de données.

9. Circuit selon la revendication 8, dans une mémoire non-volatile (100), comprenant également un module tampon d'adresse (102), caractérisé en ce qu'il comprend également un moyen de blocage d'adresse (109, 110) connecté au premier circuit logique (42) et au module tampon d'adresse (102) pour empêcher la commutation du module tampon d'adresse en présence du signal de suppression de bruit (N).

10. Circuit selon l'une quelconque des revendications 5 à 9, caractérisé en ce que le moyen d'extension de chargement comprend un moyen de retard (51) ayant une entrée connectée au moyen générateur de simulation (24) et recevant le signal de simulation de données (SP) ; une seconde entrée connectée au moyen de détection de propagation (38) et recevant le signal d'invalidation (EP) ; et une sortie fournissant le signal de chargement étendu (STP) validé à la suite de la réception du signal de simulation de données et invalidé avec un retard prédéterminé après détection du signal d'invalidation.

11. Circuit selon l'une quelconque des revendications 5 à 10, caractérisé en ce que le moyen de validation sélectif (45, 69) comprend un quatrième moyen de commutation (45) interposé entre le moyen de validation simultanée (31, 42, 46, 120) et le moyen d'extension de chargement (51), et ayant au moins une borne de commande connectée à un moyen d'invalidation d'extension (47, 48).

12. Circuit selon la revendication 11, caractérisé en ce que le moyen de validation sélectif (45, 69) comprend un moyen de mise en mode statique (69) produisant un signal de mode statique (SPP) pour valider en continu le moyen d'extension de chargement (51).

13. Circuit selon l'une quelconque des revendications 8 à 12, caractérisé en ce qu'il comprend un moyen de sélection (55) ayant une première entrée connectée au moyen de validation simultanée (46), une seconde entrée connectée au moyen d'extension de chargement (51) ; et une sortie connectée à la borne de commande du troisième moyen de commutation (120) ; et en ce que le moyen de remise à zéro comprend un moyen monostable (65) ayant une entrée connectée au moyen de sélection (55) et une sortie connectée au moyen de validation de précharge (27).
